# EUROPEAN PATENT SPECIFICATION

(11) **EP 4 496 450 B1**
(45) Date of publication and mention of the grant of the patent: **06.05.2026**
(21) Application number: 23831716.8
(22) Date of filing: 09.05.2023
(51) Int. Cl.: G02F 1/1333, H10K 50/84, H10K 77/10, G02F 1/1345

(54) **DISPLAY DEVICE**
ANZEIGEVORRICHTUNG
DISPOSITIF D'AFFICHAGE

(30) Priority: 28.06.2022 KR 20220079301
(43) Date of publication of application: 22.01.2025
(73) Proprietor: Samsung Electronics Co., Ltd, Suwon-si, Gyeonggi-do 16677 (KR)
(72) Inventor: HWANG, Yongyeon, Suwon-si Gyeonggi-do 16677 (KR); LEE, Kyungmin, Suwon-si Gyeonggi-do 16677 (KR)
(74) Representative: Appleyard Lees IP LLP
(86) International application number: PCT/KR2023/006273
(87) International publication number: WO 2024/005352

(56) References cited:
- CN-A- 113 808 494
- CN-A- 113 808 494
- JP-A- 2018 169 475
- KR-A- 20080 056 867
- KR-A- 20080 107 630
- KR-A- 20120 013 664
- KR-A- 20220 026 227

## Description

### Technical Field

The disclosure relates to a display device having an improved structure of a frame on which a display panel is mounted in a bezel-less display device.

### [Background Art]

In general, a display device is a device that displays a screen, such as a monitor, a television (TV), or the like. Display devices use self-emissive display panels, such as organic light-emitting diodes (OLEDs), and non-emissive display panels, such as liquid crystal display (LCD) panels.

Recently, bezel-less display devices have become more popular due to their fuller screen and simpler design. A bezel-less display device may include a display panel that displays an image and a frame on which the display panel is mounted. When the display panel is seated on the frame, the frame may form the appearance of a four-sided border of the bezel-less display device.

The bottom of the display panel is connected to a chip-on-film (COF) that transmits a drive signal from a drive printed circuit board (PCB) to the display panel. The COF is required to be folded and organized on the back of the display panel so that it is not visible from the exterior of the product. To fold and organize the COF to the back of the display panel, first the frame at the bottom of the display panel needs to be separated from the display panel and spread away, then the COF needs to be inserted into a space between the display panel and the frame, and finally the COF needs to be folded to the back of the display panel, resulting in inconvenience. In addition, the COF may be damaged in the process of organizing the COF.

To organize the COF as described above, the frame assembled on the bottom of the display panel is assembled with a screw, so that after the COF is organized, the frame is assembled on the bottom of the display panel. However, since the frame is assembled on the bottom of the display panel by screws, a separate bracket for assembling the screws is required to be pre-assembled to the frame assembled on the bottom of the display panel. In addition, since the frame is assembled with screws to the bottom of the display panel, the screws may be exposed to the outside. CN 113808494 A describes a display device comprising a back plate, a display panel, a frame, a lower frame, a printed circuit board and a plurality of chip-on-films.

### Disclosure

### Technical Problem

Provided is a display device in which a frame on which a display panel is seated in a bezel-less display device is divided into a first frame forming an upper, left, and right border appearance of the display panel, and a second frame forming a lower border appearance of the display panel.

Further, provided is a display device in which a second frame forming a lower border appearance of a display panel is hooked to a lower portion of the display panel.

### Technical Solution

The invention is set out in the appended claims.

### Advantageous Effects

According to various embodiments of the present disclosure, breakage of the COF may be prevented when organizing the COF.

Further, by preventing breakage of the COF, quality reliability may be increased and processes may be improved.

Further, no screws are used to assemble the frame, thereby providing a design differentiation.

### Description of Drawings

FIG. 1 is a view illustrating a display device according to an embodiment.
FIG. 2 is a view illustrating a frame separated from a display panel, according to an embodiment.
FIG. 3 is a view illustrating a first frame assembled and a second frame disconnected, according to an embodiment.
FIG. 4 is a rear view of the display device shown in FIG. 3.
FIG. 5 is a view illustrating the second frame being assembled to a middle frame, according to an embodiment.
FIG. 6 is a rear view illustrating the second frame being assembled to the middle frame, according to an embodiment.
FIG. 7 is a rear view illustrating the second frame assembled to the middle frame, according to an embodiment.
FIG. 8 is an enlarged view of portion A of FIG. 5.
FIG. 9 is an enlarged view of portion B of FIG. 5.
FIG. 10 is an enlarged view illustrating the second frame and a portion of the second frame, according to an embodiment.
FIG. 11 is a view illustrating an assembly groove formed by dividing the assembly groove shown in FIG. 10 into a first assembly groove and a second assembly groove.
FIG. 12 is a cross-sectional view illustrating an end of the first frame assembled to a pair of second hooks of the middle frame, according to an embodiment.
FIG. 13 is a view illustrating an end of the second frame assembled to the pair of second hooks of the middle frame to which the end of the first frame is assembled, according to an embodiment.
FIG. 14 is a cross-sectional view illustrating the ends of the first and second frames assembled on the pair of second hooks of the middle frame, according to an embodiment.
FIG. 15 is a view illustrating the frame separated from the display panel, according to an embodiment.
FIG. 16 is a view illustrating a first frame assembled and a second frame disassembled, according to an embodiment.
FIG. 17 is a view illustrating the second frame being assembled to a middle frame, according to an embodiment.
FIG. 18 is a cross-sectional view illustrating an end of the first frame assembled to a pair of second hooks of the middle frame, according to an embodiment.
FIG. 19 is a view illustrating an end of the second frame assembled on the pair of second hooks of the middle frame to which the end of the first frame is assembled, according to an embodiment.
FIG. 20 is a cross-sectional view illustrating the ends of the first and second frames assembled on the pair of second hooks of the middle frame, according to an embodiment.
FIG. 21 is a view illustrating a frame separated from the display panel, according to an embodiment.
FIG. 22 is a view illustrating a first frame assembled and a second frame separated, according to an embodiment.
FIG. 23 is a view illustrating the second frame being assembled to a middle frame, according to an embodiment.
FIG. 24 is a rear view of the second frame assembled to the middle frame, according to an embodiment.

### Modes of the Invention

Embodiments described in the disclosure and configurations shown in the drawings are merely examples of the embodiments of the disclosure and may be modified in various different ways at the time of filing of the present application to replace the embodiments and drawings of the disclosure.

In connection with the description of the drawings, similar reference numerals may be used for similar or related components.

Also, the terms used herein are used to describe the embodiments and are not intended to limit and/or restrict the disclosure. The singular forms "a," "an" and "the" are intended to include the plural forms as well, unless the context clearly indicates otherwise. In this disclosure, the terms "including", "having", and the like are used to specify features, figures, steps, operations, elements, components, or combinations thereof, but do not preclude the presence or addition of one or more of the features, figures, steps, operations, elements, components, or combinations thereof.

It will be understood that, although the terms "first", "second", "primary", "secondary", etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

As used herein, the terms "front", "rear", "upper", "lower", "left", "right", and the like are defined with reference to the drawings and are not intended to limit the shape and location of each component.

Hereinafter, various embodiments of the disclosure will be described in detail with reference to the accompanying drawings.

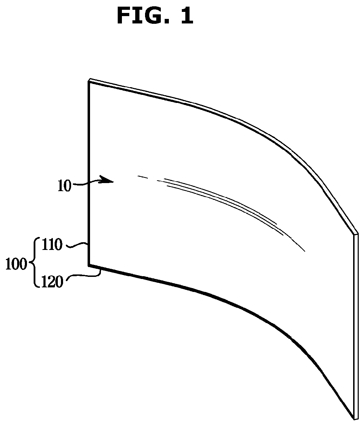

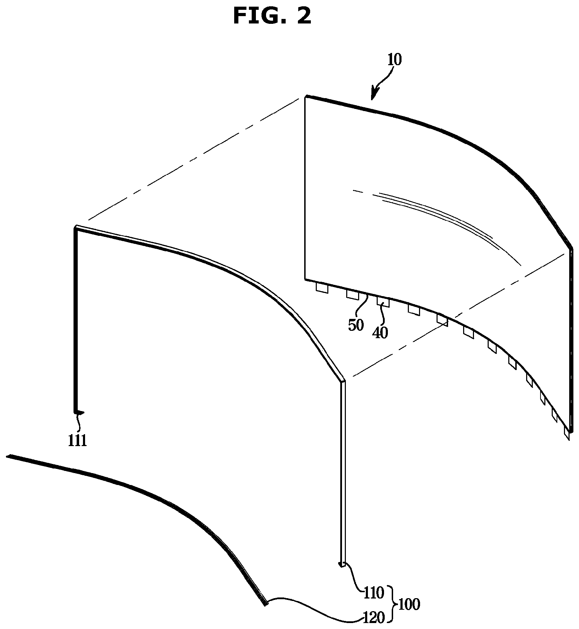

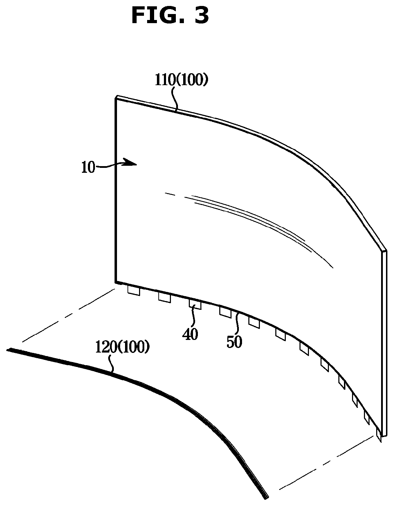

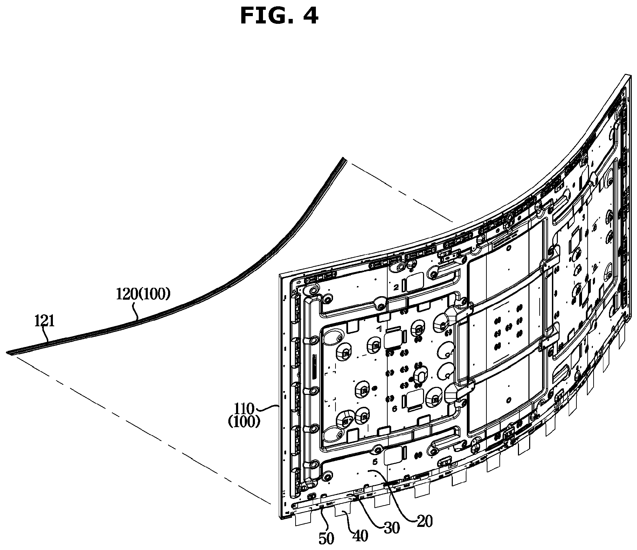

FIG. 1 is a view illustrating a display device according to an embodiment. FIG. 2 is a view illustrating a frame separated from a display panel, according to an embodiment. FIG. 3 is a view illustrating a first frame assembled and a second frame disconnected, according to an embodiment. FIG. 4 is a rear view of the display device shown in FIG. 3.

As shown in FIGS. 1 to 4, the display device may be a curved display device. The display device may be a bezel-less display device. The display device may include an analog television (TV), a digital TV, a three-dimensional (3D) TV, a smart TV, a light emitting diode (LED) TV, an organic light emitting diode (OLED) TV, a plasma TV, a quantum dot TV, and/or a monitor. However, the display device is not limited to a curved display device. In other words, the display device may be a flat panel display device.

The display device may include a display module that displays image information and a stand (not shown) that rotatably supports the display module.

The display module includes a display panel 10 that displays an image, and may include a backlight unit (not shown) disposed on a rear side of the display panel 10 to emit light to the display panel 10, includes a bottom chassis 20 which may be disposed on a rear side of the backlight unit, which is the rear side of the display panel 10, and a frame 100 on which the display panel 10 is seated. Since the display device is a bezel-less display device, i.e., without a bezel, the frame 100 on which the display panel 10 is seated may cover four side borders of the display panel 10. A rear cover (not shown) may be assembled on a rear side of the bottom chassis 20. The rear cover may form a rear exterior of the display device.

A drive printed circuit board (PCB) 30 may be mounted on the rear side of the bottom chassis 20. The drive PCB 30 may transmit a drive signal to the display panel 10. The drive PCB 30 may convert an electrical signal provided from the outside into an image and sound and transmit the converted signal to the display panel 10. Although the drive PCB 30 is shown as being mounted on the rear side of the bottom chassis 20 in the drawings, it is not limited thereto. In other words, the drive PCB 30 may be mounted on a front side of the rear cover (not shown). In addition, the drive PCB 30 may be mounted on the rear side of the display panel 10.

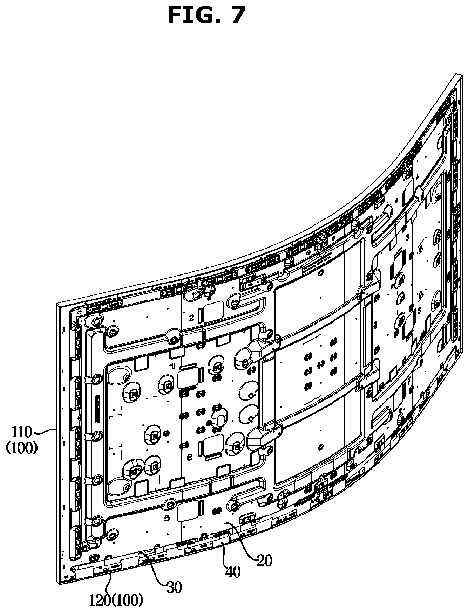

The drive PCB 30 may be connected to the display panel 10 by a chip-on-film (COF) 40. The COF 40 may be integrally formed of a bendable film cable made of a flexible material and a driver integrated circuit (IC). The driver IC may receive a drive signal and image and audio data through the film cable, and may transmit the drive signal and image and audio data to the display panel 10 through the film cable. The COF 40 may be connected to a lower end of the display panel 10 on one side and to the drive PCB 30 on the other side (see FIG. 7).

A middle frame 50 is provided at the lower end of the display panel 10. The middle frame 50 may be injection molded. The middle frame 50 is provided at the lower end of the display panel 10 and may be exposed to the outside. The middle frame 50 may be formed to have a length corresponding to the lower end of the display panel 10. The middle frame 50 may guide the COF 40 connected to the lower end of the display panel 10 to bend toward the rear side of the display panel 10. A detailed description of the middle frame 50 will be described below.

The display panel 10 may be seated on the frame 100. The frame 100 may be extrusion molded. The frame 100 may cover the four side borders of the display panel 10 without a bezel. In other words, the frame 100 may cover an upper, lower, left, and right borders of the display panel 10. The frame 100 may form an appearance of the four side borders of the display panel 10.

The frame 100 includes a first frame 110 formed in a C-shape to cover the upper, left, and right borders of the display panel 10. The display panel 10 is seated on the first frame 110. Based on the display panel 10 being seated on the first frame 110, the lower end of the display panel 10 may be exposed to the outside because the first frame 110 is formed in the C-shape to cover the upper, left, and right borders of the display panel 10. In other words, based on the display panel 10 being seated on the first frame 110, the middle frame 50 provided at the lower end of the display panel 10 is exposed to the outside.

The frame 100 includes a second frame 120 formed in a bar shape to cover the lower border of the display panel 10. The second frame 120 is assembled to the middle frame 50 at the lower end of display panel 10 exposed to the outside.

The first frame 110 and the second frame 120 may be provided separately to cover the four side borders of the display panel 10. In other words, after the display panel 10 is seated on the first frame 110, the second frame 120 covering the lower border of the display panel 10 may be hook-assembled to the middle frame 50 after the COF 40 connected to the lower end of the display panel 10 is bent toward the rear side of the display panel 10, which will be described in detail later.

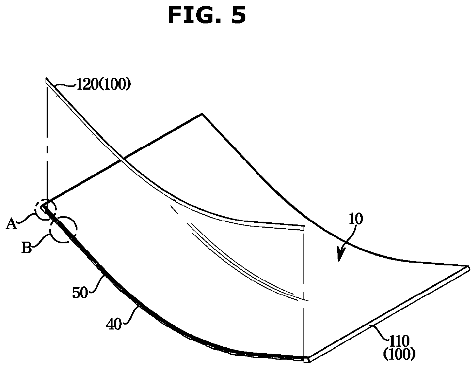

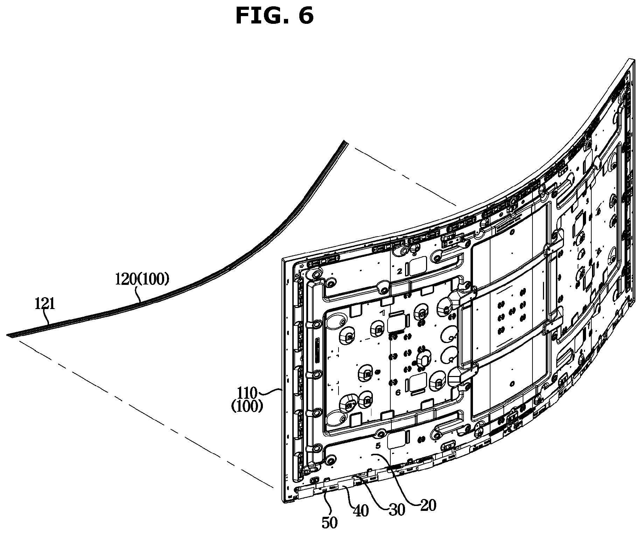

FIG. 5 is a view illustrating the second frame being assembled to the middle frame, according to an embodiment. FIG. 6 is a rear view illustrating the second frame being assembled to the middle frame, according to an embodiment. FIG. 7 is a rear view illustrating the second frame assembled to the middle frame, according to an embodiment.

As shown in FIGS. 5 to 7, the COF 40 connected to the lower end of the display panel 10 may be guided by the middle frame 50 to bend toward the rear side of the display panel 10. In other words, the COF 40 may be organized by being bent toward the rear side of the display panel 10 so as to prevent the COF from being exposed to the outside.

The COF 40 bent toward the rear side of the display panel 10 may be connected to the drive PCB 30 mounted on the rear side of the bottom chassis 20. In other words, the COF 40 may be connected at one end to the lower end of the display panel 10 and at the other end to the drive PCB 30 to transmit drive signals and image and audio data to the display panel 10.

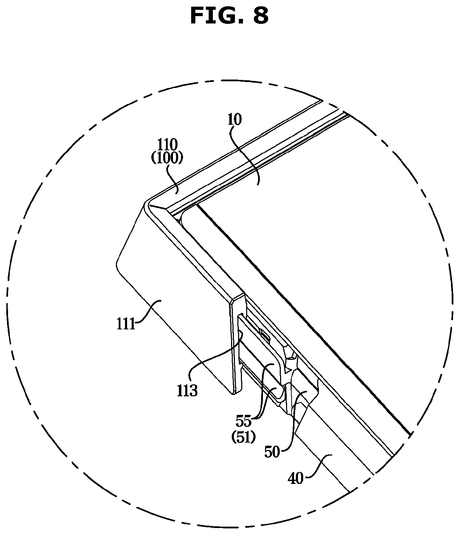

Once the COF 40 is bent toward the rear side of the display panel 10 and connected to the drive PCB 30, the second frame 120 may be assembled to the middle frame 50. The second frame 120 may be hook-assembled to the middle frame 50 (see FIGS. 8 to 13).

Next, an end of the first frame and the second frame being hook-assembled to the middle frame will be described in detail with reference to FIGS. 8 to 14.

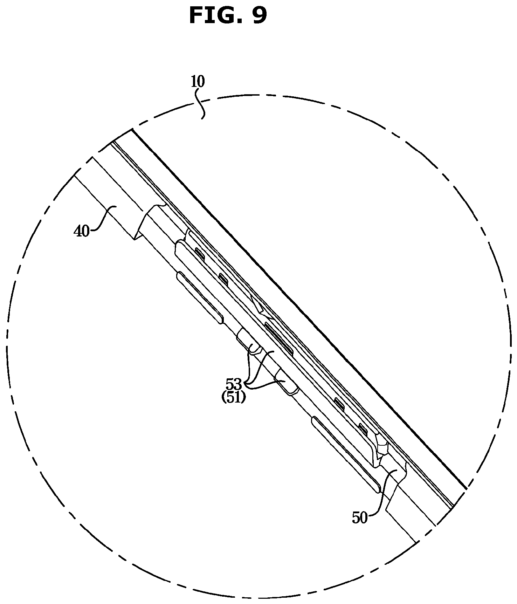

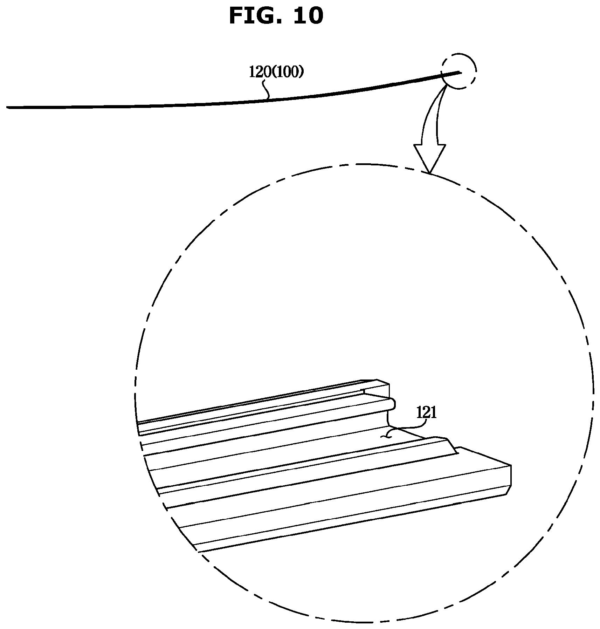

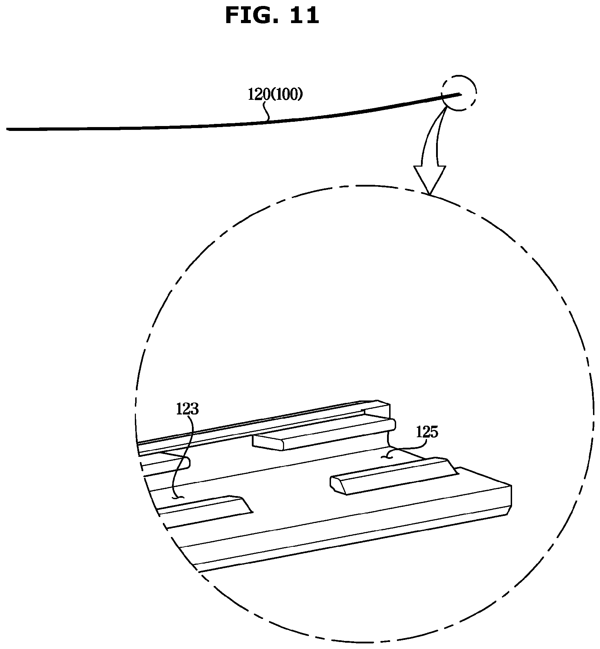

FIG. 8 is an enlarged view of portion A of FIG. 5. FIG. 9 is an enlarged view of portion B of FIG. 5. FIG. 10 is an enlarged view illustrating the second frame and a portion of the second frame, according to an embodiment. FIG. 11 is a view illustrating an assembly groove formed by dividing the assembly groove shown in FIG. 10 into a first assembly groove and a second assembly groove.

As shown in FIGS. 8 to 10, the middle frame 50 includes a plurality of hooks 51. The plurality of hooks 51 includes a plurality of first hooks 53 to which the second frame 120 is assembled. The plurality of first hooks 53 may be formed on all but opposite ends of the middle frame 50. The second frame 120 includes an assembly groove 121 that is assembled to the plurality of first hooks 53. As described above, since the second frame 120 is assembled by the plurality of first hooks 53 formed on the middle frame 50, a separate bracket may not be required other than the middle frame 50. In other words, in the event that the second frame 120 assembled to the lower end of the display panel 10 is assembled to the middle frame 50 by a screw, a separate bracket for assembling the screw may be required to be assembled to the frame 100 in advance. However, since the second frame 120 is assembled by the plurality of first hooks 53 formed directly on the middle frame 50, a separate bracket for assembling the screw may not be required (see FIG. 5).

The plurality of hooks 51 includes a pair of second hooks 55 to which opposite ends of the first frame 110 and opposite ends of the second frame 120 are assembled. The pair of second hooks 55 are formed at opposite ends of the middle frame 50. The first frame 110 may include the hook grooves 113 formed at opposite ends of the first frame 110 and assembled to the pair of second hooks 55. The second frame 120 may include the assembly grooves 121 formed at opposite ends of the second frame 120 that are assembled to the pair of second hooks 55. Accordingly, among the assembly grooves 121 formed in the second frame 120, the assembly grooves 121 formed at opposite ends of the second frame 120 may be assembled to the pair of second hooks 55. In addition, among the assembly grooves 121 formed in the second frame 120, the assembly grooves 121 formed between the opposite ends of the second frame 120 may be assembled to the plurality of first hooks 53. In other words, the assembly grooves 121 may be formed by being connected to a single groove.

As shown in FIG. 11, the assembly grooves 121 may include a first assembly groove 123 in which the plurality of first hooks 53 is assembled, and a second assembly groove 125 in which the pair of second hooks 55 are assembled. In other words, the assembly grooves 121 may include a plurality of first assembly grooves 123 formed between the opposite ends of the second frame 120 to correspond to the plurality of first hooks 53, and a pair of second assembly grooves 123 formed at each of the opposite ends of the second frame 120. The first assembly grooves 123 may each be formed at a position corresponding to the plurality of first hooks 53. However, the present disclosure is not limited thereto, and the first assembly grooves 123 may be formed by being connected to a single groove. In other words, the first assembly grooves 123 may be formed by being connected to a single groove so as to be separated from the pair of second assembly grooves 123.

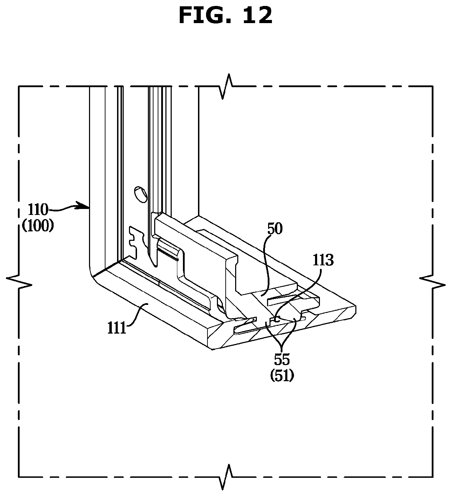

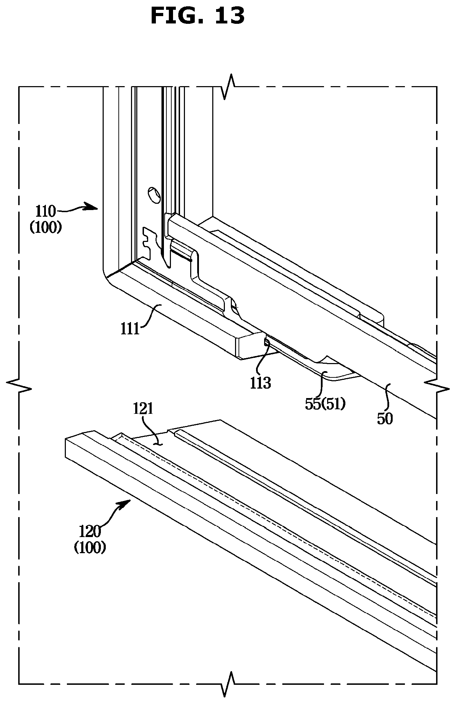

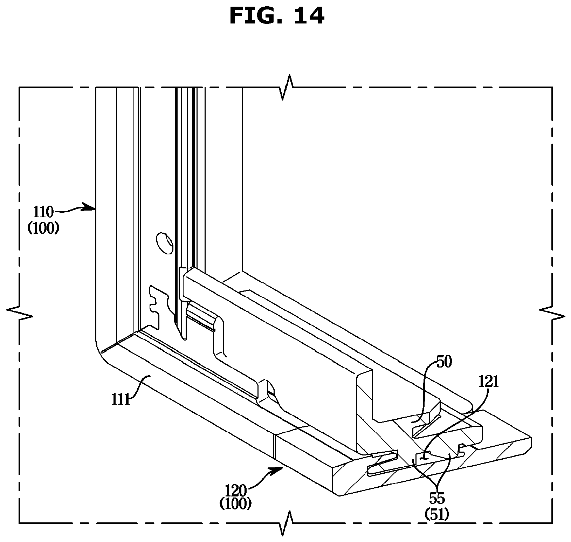

FIG. 12 is a cross-sectional view illustrating an end of the first frame assembled to the pair of second hooks of the middle frame, according to an embodiment. FIG. 13 is a view illustrating an end of the second frame assembled to the pair of second hooks of the middle frame to which the end of the first frame is assembled, according to an embodiment. FIG. 14 is a cross-sectional view illustrating the ends of the first and second frames assembled on the pair of second hooks of the middle frame, according to an embodiment.

As shown in FIG. 12, when the display panel 10 is seated on the first frame 110, each of the opposite ends of the first frame 110 may be assembled to the middle frame 50. The first frame 110 may include extensions 111 extending horizontally from the left and right ends of the first frame 110 corresponding to the left and right ends of the display panel 10 such that the opposite ends of the first frame 110 are assembled to the middle frame 50. The left end of the display panel 10 may be a lower left end of the display panel 10. The right end of the display panel 10 may be a lower right end of the display panel 10. Accordingly, the extensions 111 of the first frame 110 may extend horizontally from the left and right ends of the first frame 110 toward the middle frame 50, respectively. In other words, the extension 111 extending from a left end of the first frame 110 may extend in a right direction. In addition, the extensions 111 extending from a right end of the first frame 110 may extend in a left direction (see FIG. 3).

The extensions 111 may be extended so that the corners of the display panel 10 have a rounded shape. In other words, since the corners of the first frame 110 covering the border of the display panel 10 are extended to have a rounded shape, the corners of the display panel 10 may be extended to have a rounded shape. This may prevent a user from being injured by the corners of the display panel 10 (see FIG. 3).

As shown in FIGS. 13 and 14, with the display panel 10 seated on the first frame 110, the second frame 120 may be assembled to the middle frame 50. The assembly grooves 121 formed at the opposite ends of the second frame 120 may be assembled to the pair of second hooks 55 of the middle frame 50. In other words, a portion of the pair of second hooks 55 may be assembled into the assembly grooves 121 formed at the opposite ends of the second frame 120, and the remaining portion may be assembled into the hook grooves 113 of the first frame 110.

Each of the pair of second hooks 55 may be integrally formed. Since each of the pair of second hooks 55 formed integrally is partially assembled into the first frame 110, and partially assembled into the second frame 120, a step between the end of the first frame 110 and the end of the second frame 120 may be prevented from occurring when the second frame 120 is assembled to the middle frame 50. In other words, when the second frame 120 is assembled to the middle frame 50, the extension 111, which is the end of the first frame 110, and the end of the second frame 120 may be in contact. Since the end of the first frame 110 and the end of the second frame 120 that are in contact are assembled to one second hook 55, the step between the end of the first frame 110 and the end of the second frame 120 may be prevented from occurring.

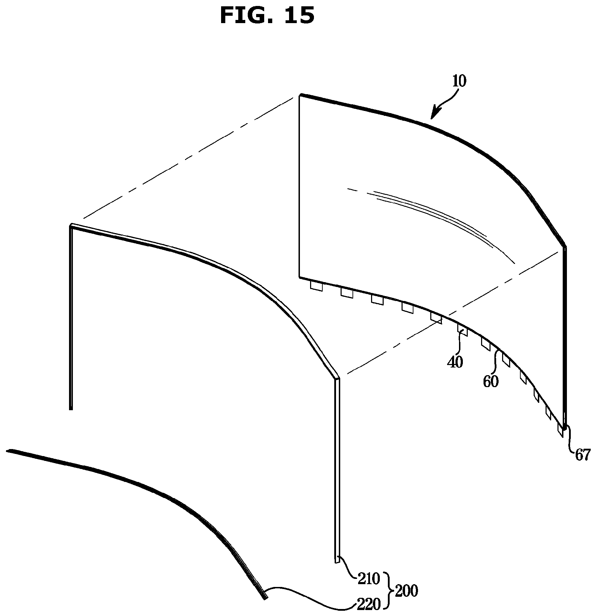

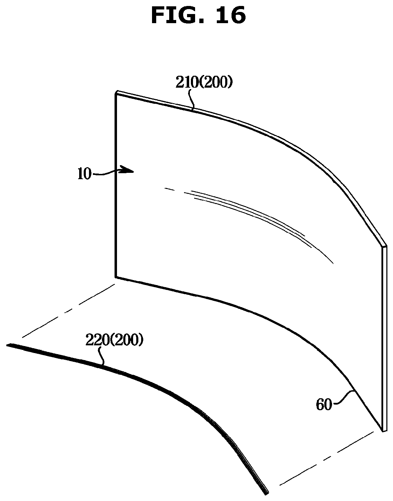

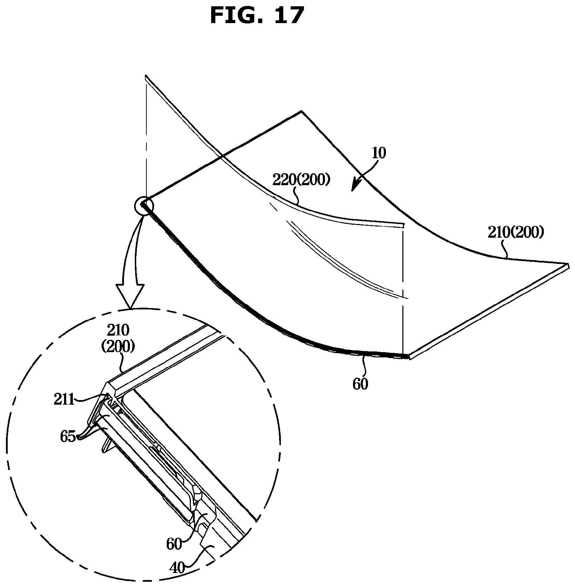

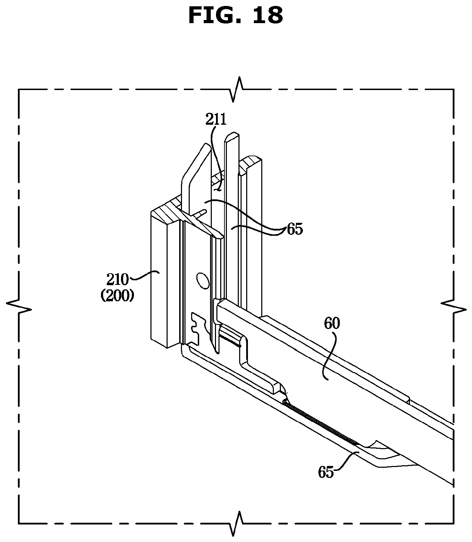

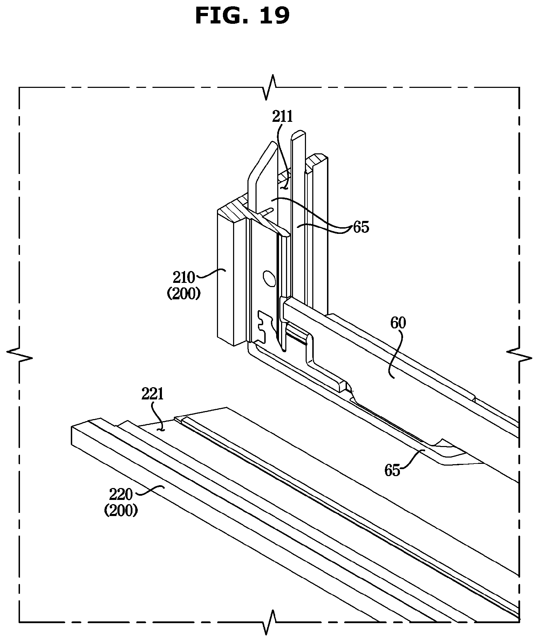

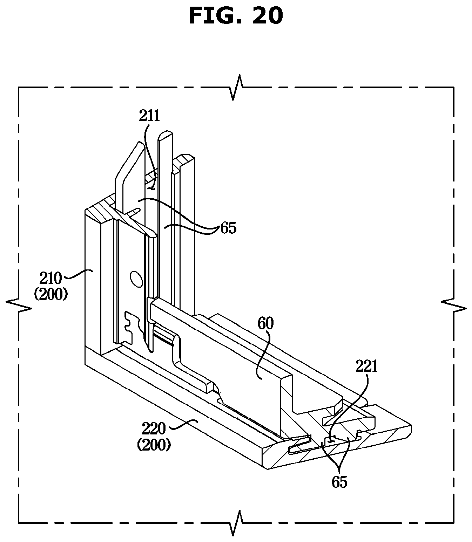

FIG. 15 is a view illustrating the frame separated from the display panel, according to an embodiment. FIG. 16 is a view illustrating a first frame assembled and a second frame disassembled, according to an embodiment. FIG. 17 is a view illustrating the second frame being assembled to a middle frame, according to an embodiment. FIG. 18 is a cross-sectional view illustrating an end of the first frame, according to an embodiment, assembled to a pair of second hooks of the middle frame. FIG. 19 is a view illustrating an end of the second frame assembled on the pair of second hooks of the middle frame to which the end of the first frame is assembled, according to an embodiment. FIG. 20 is a cross-sectional view illustrating the ends of the first and second frames assembled on the pair of second hooks of the middle frame, according to an embodiment.

As shown in FIGS. 15 and 16, the display device may include a display module that displays image information and a stand (not shown) that rotatably supports the display module.

All configurations of the display module including the display panel 10, a frame 200 on which the display panel 10 is seated, and the like may be the same as the configurations shown in FIGS. 1 to 14. Accordingly, only configurations different from the configuration of the display device shown in FIGS. 1 to 14 will be described.

Although all of the configurations according to an embodiment are the same as the configurations of the display device shown in FIGS. 1 to 14, a configuration of the frame 200 on which the display panel 10 is seated and a configuration of the middle frame 60 on which an end of the first frame 210 and a second frame 220 are assembled may be partially different. Accordingly, only some different configurations will be described, and all configurations that are not described may be the same.

The middle frame 60 may be provided at the lower end of the display panel 10. The middle frame 60 may be injection molded. The middle frame 60 may be provided at the lower end of the display panel 10 and may be exposed to the outside. The middle frame 60 may include extensions 67 extending vertically upward from the left and right ends of the middle frame 60 corresponding to opposite ends of the lower end of the display panel 10. The middle frame 60 may guide the COF 40 connected to the lower end of the display panel 10 to bend toward the rear side of the display panel 10. The middle frame 60 will be described in more detail below.

The display panel 10 may be seated on the frame 200. The frame 200 may be extrusion molded. The frame 200 may cover the four side borders of the display panel 10 without a bezel. In other words, the frame 200 may cover the upper, lower, left, and right borders of the display panel 10. The frame 200 may form the appearance of the four side borders of the display panel 10.

The frame 200 may include the first frame 210 formed in a C-shape to cover the upper, left, and right borders of the display panel 10. The display panel 10 may be seated on the first frame 210. Based on the display panel 10 being seated on the first frame 210, the lower end of the display panel 10 may be exposed to the outside because the first frame 210 is formed in the C-shape to cover the upper, left, and right borders of the display panel 10. In other words, based on the display panel 10 being seated on the first frame 210, the middle frame 60 provided at the lower end of the display panel 10 may be exposed to the outside.

The frame 200 may include the second frame 220 formed in a bar shape to cover the lower border of the display panel 10. The second frame 220 may be assembled to the middle frame 60 at the lower end of the display panel 10 exposed to the outside.

The first frame 210 and the second frame 220 may be provided separately to cover the four side borders of the display panel 10. In other words, after the display panel 10 is seated on the first frame 210, the second frame 220 covering the lower border of the display panel 10 may be hook-assembled to the middle frame 60 after the COF 40 connected to the lower end of the display panel 10 is bent toward the rear side of the display panel 10.

As shown in FIGS. 17 to 20, when the display panel 10 is seated on the first frame 210, the opposite ends of the first frame 210 may be assembled to the middle frame 60, respectively. The middle frame 60 may include the extensions 67 extending vertically upward from the left and right ends of the middle frame 60 corresponding to the opposite ends of the lower end of the display panel 10 such that the opposite ends of the first frame 210 may be assembled to the middle frame 60 (see FIG. 15).

With the display panel 10 seated on the first frame 210, the second frame 220 may be assembled to the middle frame 60. Assembly grooves 221 formed at the opposite ends of the second frame 220 may be assembled to a pair of second hooks 65 of the middle frame 60. In other words, a portion of the second hooks 65 may be assembled into the assembly grooves 221 formed at the opposite ends of the second frame 220, and the remaining portion may be assembled into hook grooves 211 of the first frame 210.

Each of the pair of second hooks 65 may be integrally formed. A portion of each of the pair of second hooks 65 formed integrally may be partially formed on the extensions 67 to be assembled to the first frame 210, and the remaining portion may be assembled to the second frame 220. In other words, the pair of second hooks 65 formed on the middle frame 60 may be formed in an L-shape. Since each of the pair of second hooks 65 formed integrally is partially assembled to the first frame 210, and partially assembled to the second frame 220, a step between the end of the first frame 210 and the end of the second frame 220 may be prevented from occurring when the second frame 220 is assembled to the middle frame 60. In other words, when the second frame 220 is assembled to the middle frame 60, the end of the first frame 210 and the end of the second frame 220 may be in contact. Since the end of the first frame 210 and the end of the second frame 220 that are in contact are assembled to one second hook 65, the step between the end of the first frame 210 and the end of the second frame 220 may be prevented from occurring.

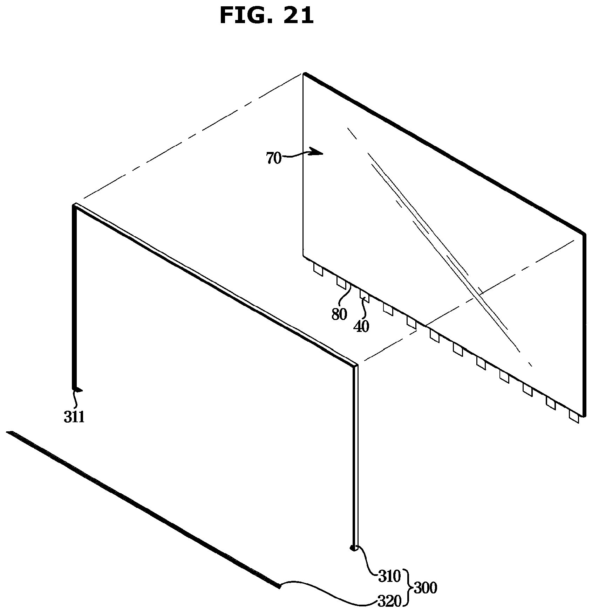

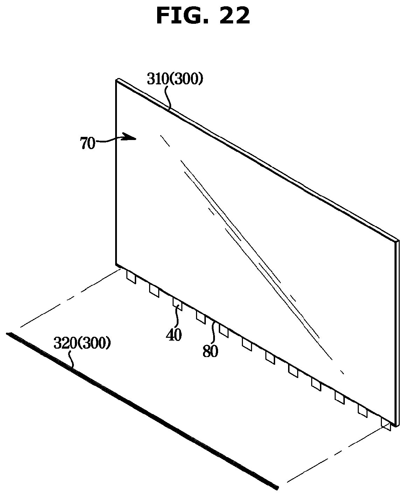

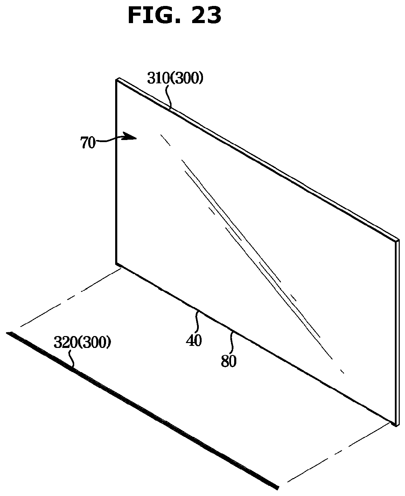

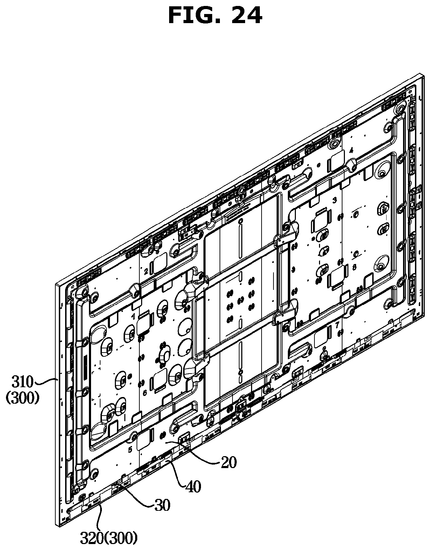

FIG. 21 is a view illustrating a frame separated from the display panel, according to an embodiment. FIG. 22 is a view illustrating a first frame assembled and a second frame separated, according to an embodiment. FIG. 23 is a view illustrating the second frame being assembled to a middle frame, according to an embodiment. FIG. 24 is a rear view of the second frame assembled to the middle frame, according to an embodiment.

As shown in FIGS. 21 to 24, the display device may include a display module that displays image information and a stand (not shown) that rotatably supports the display module.

All configurations of the display module including a display panel 70, a frame 300 on which the display panel 70 is seated may be the same as the configurations shown in FIGS. 1 to 14. However, the display device may be a flat panel display device in which the display panel 70 is a flat surface. In other words, the shape of the display panel 70 may be different from the configurations shown in FIGS. 1 to 14 in that the display panel 70 is a rectangular flat surface. In addition, the shapes of a middle frame 80 and the frame 300 may be different from the shapes of the middle frame 40 and the frame 100 shown in FIGS. 1 to 14 in order to correspond to the shape of the display panel 70. Except for some of the configurations described above, all of the remaining configurations thereof may be the same, so that their descriptions will be omitted.

Although certain example embodiments are illustrated and described above, the present disclosure is not limited to the certain embodiments, various applications may of course be performed by those skilled in the art without deviating from what is claimed in the scope of claims, and such applications should not be understood separately from the technical idea or prospects herein.

## Claims

1. A display device comprising:
a display panel (10, 70);
a bottom chassis (20) disposed on a rear side of the display panel;
a middle frame (50, 60, 80) disposed on a lower end of the display panel, and including a plurality of hooks (51);
a first frame (110, 210) on which the display panel is seated, and formed in a C-shape to cover upper, left, and right borders of the display panel to cause the middle frame on the lower end of the display panel to be exposed; and
a second frame (120, 220) including an assembly groove (121, 221) assembled to the plurality of hooks, and formed in a bar shape to cover a lower border of the display panel by being assembled to the middle frame;
wherein the plurality of hooks comprises:
a plurality of first hooks (53) assembled to the assembly groove to allow the second frame to be assembled to the middle frame, and
a pair of second hooks (55, 65) formed at opposite ends of the middle frame and assembled to opposite ends of the first frame in contact with opposite ends of the second frame together with the assembly groove formed at the opposite ends of the second frame.

2. The display device of claim 1, wherein a chip-on film, COF, (40) is connected to the lower end of the display panel and configured to transmit a drive signal from a drive printed circuit board (30) to the display panel.

3. The display device of claim 2, wherein the COF is guided by the middle frame to bend toward the rear side of the display panel in order to prevent the COF from being exposed to the outside, and the second frame is assembled to the middle frame after the COF is bent.

4. The display device of claim 1, wherein the first frame includes a hook groove (113, 211) formed at the opposite ends of the first frame and in which the pair of second hooks are assembled.

5. The display device of claim 4, wherein a portion of the pair of the second hooks is assembled into the assembly groove formed at the opposite ends of the second frame, and the remaining portion is assembled into the hook groove, so that when the second frame is assembled to the middle frame, a step between the end of the first frame and the end of the second frame is prevented from occurring.

6. The display device of claim 1, wherein the middle frame is formed to have a length corresponding to the lower end of the display panel.

7. The display device of claim 6, wherein the first frame includes an extension (111) extending horizontally from left and right ends of the first frame corresponding to left and right ends of the display panel so as to be assembled to the middle frame.

8. The display device of claim 7, wherein the extension is extended so that corners of the display panel have a rounded shape.

9. The display device of claim 7, wherein each of the pair of second hooks is integrally formed, a portion of which is assembled to the second frame, and the remaining portion of which is assembled to the extension.

10. The display device of claim 1, wherein the middle frame includes an extension (67) extending vertically from left and right ends of the middle frame corresponding to opposite ends of the lower end of the display panel.

11. The display device of claim 10, wherein the first frame is formed so that left and right ends of the first frame have a length corresponding to left and right ends of the display panel so as to be assembled to the extension.

12. The display device of claim 11, wherein each of the pair of second hooks is integrally formed, a portion of which is formed on the extension to be assembled to the first frame, and the remaining portion of which is assembled to the second frame.

13. The display device of claim 1, wherein the assembly groove includes a first assembly groove (123) in which the plurality of first hooks is assembled, and a second assembly groove (125) in which the pair of second hooks is assembled.

14. The display device of claim 13, wherein the first assembly groove and the second assembly groove are formed by being connected to a single groove.

15. The display device of claim 13, wherein the first assembly groove is formed in a plurality at positions corresponding to the plurality of first hooks, and the second assembly groove is formed at the opposite ends of the second frame to correspond to the pair of second hooks.

## Patentansprüche

1. Anzeigevorrichtung, umfassend:
ein Anzeigefeld (10, 70);
ein unteres Chassis (20), das auf einer Rückseite des Anzeigefelds angeordnet ist;
einen mittleren Rahmen (50, 60, 80), der an einem unteren Ende des Anzeigefelds angeordnet ist und eine Vielzahl von Haken (51) beinhaltet;
einen ersten Rahmen (110, 210), auf dem das Anzeigefeld sitzt und der in einer C-Form ausgebildet ist, um obere, linke und rechte Ränder des Anzeigefelds abzudecken, um zu bewirken, dass der mittlere Rahmen an dem unteren Ende des Anzeigefelds freigelegt wird; und
einen zweiten Rahmen (120, 220), der eine Montagenut (121, 221) beinhaltet, die an der Vielzahl von Haken montiert ist und in einer Stabform ausgebildet ist, um einen unteren Rand des Anzeigefelds abzudecken, indem sie an dem mittleren Rahmen montiert ist;
wobei die Vielzahl von Haken Folgendes umfasst:
eine Vielzahl von ersten Haken (53), die an der Montagenut montiert sind, um zu ermöglichen, dass der zweite Rahmen an dem mittleren Rahmen montiert wird, und
ein Paar zweiter Haken (55, 65), die an gegenüberliegenden Enden des mittleren Rahmens ausgebildet sind und an gegenüberliegenden Enden des ersten Rahmens in Kontakt mit gegenüberliegenden Enden des zweiten Rahmens zusammen mit der Montagenut, die an den gegenüberliegenden Enden des zweiten Rahmens ausgebildet ist, montiert sind.

2. Anzeigevorrichtung nach Anspruch 1, wobei eine Chip-On-Folie, COF, (40) mit dem unteren Ende des Anzeigefelds verbunden ist und dazu konfiguriert ist, ein Ansteuersignal von einer Ansteuerleiterplatte (30) an das Anzeigefeld zu übertragen.

3. Anzeigevorrichtung nach Anspruch 2, wobei die COF durch den mittleren Rahmen geführt wird, um sich in Richtung der Rückseite des Anzeigefelds zu biegen, um zu verhindern, dass die COF nach außen freiliegt, und der zweite Rahmen an dem mittleren Rahmen nach dem Biegen der COF montiert wird.

4. Anzeigevorrichtung nach Anspruch 1, wobei der erste Rahmen eine Hakennut (113, 211) beinhaltet, die an den gegenüberliegenden Enden des ersten Rahmens ausgebildet ist und in der das Paar zweiter Haken montiert ist.

5. Anzeigevorrichtung nach Anspruch 4, wobei ein Abschnitt des Paars der zweiten Haken in die Montagenut montiert ist, die an den gegenüberliegenden Enden des zweiten Rahmens ausgebildet ist, und der verbleibende Abschnitt in die Hakennut montiert ist, sodass, wenn der zweite Rahmen an dem mittleren Rahmen montiert ist, verhindert wird, dass eine Stufe zwischen dem Ende des ersten Rahmens und dem Ende des zweiten Rahmens auftritt.

6. Anzeigevorrichtung nach Anspruch 1, wobei der mittlere Rahmen so ausgebildet ist, dass er eine Länge aufweist, die dem unteren Ende des Anzeigefelds entspricht.

7. Anzeigevorrichtung nach Anspruch 6, wobei der erste Rahmen eine Verlängerung (111) beinhaltet, die sich horizontal von einem linken und einem rechten Ende des ersten Rahmens erstreckt, die einem linken und einem rechten Ende des Anzeigefelds entsprechen, um an dem mittleren Rahmen montiert zu werden.

8. Anzeigevorrichtung nach Anspruch 7, wobei die Verlängerung so verlängert ist, dass Ecken des Anzeigefelds eine abgerundete Form aufweisen.

9. Anzeigevorrichtung nach Anspruch 7, wobei jeder von dem Paar zweiter Haken einstückig ausgebildet ist, wobei ein Abschnitt davon an dem zweiten Rahmen montiert ist und der verbleibende Abschnitt davon an der Verlängerung montiert ist.

10. Anzeigevorrichtung nach Anspruch 1, wobei der mittlere Rahmen eine Verlängerung (67) beinhaltet, die sich vertikal von einem linken und einem rechten Ende des mittleren Rahmens erstreckt, die gegenüberliegenden Enden des unteren Endes des Anzeigefelds entsprechen.

11. Anzeigevorrichtung nach Anspruch 10, wobei der erste Rahmen so ausgebildet ist, dass ein linkes und ein rechtes Ende des ersten Rahmens eine Länge aufweisen, die einem linken und einem rechten Ende des Anzeigefelds entspricht, um an der Verlängerung montiert zu werden.

12. Anzeigevorrichtung nach Anspruch 11, wobei jeder von dem Paar zweiter Haken einstückig ausgebildet ist, wobei ein Abschnitt davon an der Verlängerung ausgebildet ist, die an dem ersten Rahmen zu montieren ist, und der verbleibende Abschnitt davon an dem zweiten Rahmen montiert ist.

13. Anzeigevorrichtung nach Anspruch 1, wobei die Montagenut eine erste Montagenut (123), in der die Vielzahl von ersten Haken montiert ist, und eine zweite Montagenut (125), in der das Paar zweiter Haken montiert ist, beinhaltet.

14. Anzeigevorrichtung nach Anspruch 13, wobei die erste Montagenut und die zweite Montagenut ausgebildet sind, indem sie mit einer einzelnen Nut verbunden sind.

15. Anzeigevorrichtung nach Anspruch 13, wobei die erste Montagenut in einer Vielzahl an Positionen ausgebildet ist, die der Vielzahl von ersten Haken entsprechen, und die zweite Montagenut an den gegenüberliegenden Enden des zweiten Rahmens ausgebildet ist, um dem Paar zweiter Haken zu entsprechen.

## Revendications

1. Dispositif d'affichage comprenant :
un panneau d'affichage (10, 70) ;
un châssis de fond (20) disposé d'un côté arrière du panneau d'affichage ;
un cadre central (50, 60, 80) disposé sur une extrémité inférieure du panneau d'affichage, et comprenant une pluralité de crochets (51) ;
un premier cadre (110, 210) sur lequel le panneau d'affichage est placé, et formé en forme de C pour couvrir des bordures supérieure, gauche et droite du panneau d'affichage pour amener le cadre central sur l'extrémité inférieure du panneau d'affichage à être exposé ; et
un second cadre (120, 220) comprenant une rainure d'assemblage (121, 221) assemblée à la pluralité de crochets, et formée en forme de barre pour couvrir une bordure inférieure du panneau d'affichage en étant assemblée au cadre central ;
dans lequel la pluralité de crochets comprend :
une pluralité de premiers crochets (53) assemblés à la rainure d'assemblage pour permettre au second cadre d'être assemblé au cadre central, et
une paire de seconds crochets (55, 65) formés à des extrémités opposées du cadre central et assemblés à des extrémités opposées du premier cadre en contact avec des extrémités opposées du second cadre, la rainure d'assemblage étant formée aux extrémités opposées du second cadre.

2. Dispositif d'affichage de la revendication 1, dans lequel une puce sur film, COF, (40) est reliée à l'extrémité inférieure du panneau d'affichage et configurée pour transmettre un signal de commande provenant d'une carte de circuit imprimé de commande (30) au panneau d'affichage.

3. Dispositif d'affichage de la revendication 2, dans lequel la COF est guidée par le cadre central pour se courber vers le côté arrière du panneau d'affichage afin d'empêcher la COF d'être exposée à l'extérieur, et le second cadre est assemblé au cadre central après la courbure de la COF.

4. Dispositif d'affichage de la revendication 1, dans lequel le premier cadre comprend une rainure de crochet (113, 211) formée aux extrémités opposées du premier cadre et où la paire de seconds crochets sont assemblés.

5. Dispositif d'affichage de la revendication 4, dans lequel une partie de la paire des seconds crochets est assemblée dans la rainure d'assemblage formée aux extrémités opposées du second cadre, et la partie restante est assemblée dans la rainure de crochet, afin que, lorsque le second cadre est assemblé au cadre central, un pas entre l'extrémité du premier cadre et l'extrémité du second cadre est empêché de se produire.

6. Dispositif d'affichage de la revendication 1, dans lequel le cadre central est formé pour présenter une longueur correspondant à l'extrémité inférieure du panneau d'affichage.

7. Dispositif d'affichage de la revendication 6, dans lequel le premier cadre comprend une extension (111) s'étendant horizontalement à partir d'extrémités gauche et droite du premier cadre correspondant aux extrémités gauche et droite du panneau d'affichage de façon à être assemblée au cadre central.

8. Dispositif d'affichage de la revendication 7, dans lequel l'extension est étendue afin que des coins du panneau d'affichage présentent une forme arrondie.

9. Dispositif d'affichage de la revendication 7, dans lequel chacun de la paire de seconds crochets est formé d'un seul tenant, une partie étant assemblée au second cadre, et la partie restante étant assemblée à l'extension.

10. Dispositif d'affichage de la revendication 1, dans lequel le cadre central comprend une extension (67) s'étendant verticalement à partir d'extrémités gauche et droite du cadre central correspondant à des extrémités opposées de l'extrémité inférieure du panneau d'affichage.

11. Dispositif d'affichage de la revendication 10, dans lequel le premier cadre est formé afin que des extrémités gauche et droite du premier cadre présentent une longueur correspondant à des extrémités gauche et droite du panneau d'affichage de façon à être assemblé à l'extension.

12. Dispositif d'affichage de la revendication 11, dans lequel chacun de la paire de seconds crochets est formé d'un seul tenant, une partie étant formée sur l'extension pour être assemblé au premier cadre, et la partie restante étant assemblée au second cadre.

13. Dispositif d'affichage de la revendication 1, dans lequel la rainure d'assemblage comprend une première rainure d'assemblage (123) où la pluralité de premiers crochets est assemblée, et une seconde rainure d'assemblage (125) où la paire de seconds crochets est assemblée.

14. Dispositif d'affichage de la revendication 13, dans lequel la première rainure d'assemblage et la seconde rainure d'assemblage sont formées en étant connectées à une rainure unique.

15. Dispositif d'affichage de la revendication 13, dans lequel la première rainure d'assemblage est formée en pluralité à des positions correspondant à la pluralité de premiers crochets, et la seconde rainure d'assemblage est formée aux extrémités opposées du second cadre pour correspondre à la paire de seconds crochets.
